# EUROPÄISCHE PATENTSCHRIFT

(11) **EP 0 350 504 B1**
(45) Veröffentlichungstag und Bekanntmachung des Hinweises auf die Patenterteilung: **16.06.1993**
(21) Anmeldenummer: 89901483.1
(22) Anmeldetag: 05.12.1988
(51) Int. Cl.: B60T 8/36

(54) **VENTILBLOCKAGGREGAT**
VALVE BLOCK AGGREGATE
ENSEMBLE D'APPAREILS DE DISTRIBUTION ET DE REGULATION GROUPES

(30) Priorität: 14.12.1987 DE 3742320; 20.04.1988 DE 3813140; 20.04.1988 DE 3813141
(43) Veröffentlichungstag der Anmeldung: 17.01.1990
(73) Patentinhaber: ALFRED TEVES GmbH, 60441 Frankfurt (DE)
(72) Erfinder: MAAS, Joachim, 6368 Bad Vilbel (DE); Beck, Erhard, 6290 Weilburg (DE); SCHÜTZEICHEL, Winfried, D-6368 Bad Vilbel 2 (DE); HINZ, Axel, D-6242 Kronberg/Ts. (DE)
(86) Internationale Anmeldenummer: EP8801107
(87) Internationale Veröffentlichungsnummer: WO8905746

(56) Entgegenhaltungen:
- EP-A- 0 105 219
- DE-A- 3 013 507
- DE-A- 3 121 883
- DE-A- 3 534 665
- US-A- 3 538 947

## Beschreibung

Die Erfindung betrifft ein Ventilblockaggregat, insbesondere für Bremsdruckregelvorrichtungen, wie Antiblockierregelvorrichtungen, Antriebsschlupfregelvorrichtungen, bestehend aus einem oder mehreren elektromagnetisch betätigbaren Hydraulikventilen (Elektromagnetventilen), einem Ventilblockdeckel (Deckel), einer Stromzuführungsvorrichtung für die Strombeaufschlagung der Spulen der Elektromagnetventile.

Elektrohydraulische Steuerungen finden eine immer weitere Verbreitung in der Technik. Grund dafür ist die Möglichkeit, den Steuerteil einer Steuerkette elektrisch und den Energieteil der Steuerkette hydraulisch darzustellen. Zu den Nahtstellen zwischen elektrischem und hydraulischem Teil gehören die elektromagnetisch betätigten Hydraulikventile. Diese Ventile sind zu Baugruppen (Ventilblöcke) zusammengefaßt. Diese Baugruppen haben hydraulische Zu- und Ableitungen und einen oder mehrere Kabelabgänge. In den Kabeln sind elektrische Leitungen angeordnet für die Steuersignale zur Schaltung der elektromagnetischen Ventile, das heißt zur Strombeaufschlagung der Spulen der Elektromagnetventile.

Es existiert die ältere Deutsche Patentanmeldung P 37 42 830.6. Diese Patentanmeldung gilt nach § 3, Absatz 2, PatG., als Stand der Technik.

In dieser Patentanmeldung wird ein Ventilblockaggregat, bestehend aus einem oder mehreren elektromagnetisch betätigbaren Hydraulikventilen (Elektromagnetventilen), einem Ventildeckel (Deckel) und einer Stromzuführungsvorrichtung für die Strombeaufschlagung der Spulen der Elektromagnetventile beschrieben.

Das Besondere an diesem Ventilblockaggregat der älteren Patentanmeldung besteht darin, daß eine Platine vorgesehen ist, die auf alle elektrischen Kontaktstellen der Spulen als ein Bauelement aufsetzbar ist, die elektrische Leiterbahnen aufweist, welche die elektrischen Verbindungen zwischen den Spulen und einem Kabelabgang des Ventilblocks herstellen, daß die Platine für den Kabelabgang eine für alle Leiterbahnen gemeinsame Kontaktvorrichtung aufweist, die so ausgebildet ist, daß der abziehbare Steckkontakt (Stecker) des Anschlußkabels direkt auf die Platine, die einen Teil der Kontaktvorrichtung bildet, aufsteckbar ist.

In der Patentanmeldung P 3701019.0 wird ein Ventilblock für eine schlupfgeregelte, hydraulische Bremsanlage, bestehend aus einem, mehrere Elektromagnetventile aufnehmenden, Ventilaufnahmekörper, einem Rahmen, einem den Rahmen verschließenden Deckel, sowie einer, mehrere Kontaktmesser enthaltenden, Messerleiste, wobei die Elektromagnetventile mit den Kontaktmessern durch eine Anschlußfolie verbunden sind, beschrieben.

Das Besondere an diesem Ventilblock besteht darin, daß der Rahmen mit dem Deckel und der Messerleiste einstückig derart ausgebildet ist, daß eine einteilige Abdeckungseinheit gebildet wird, die das Verlöten der Anschlußfolie zuläßt und abgedichtet am Ventilaufnahmekörper befestigt ist.

Bei Anordnung, bestehen aus einem Ventilblock und einem dazu gehörenden Deckel, treten in der Praxis folgende Probleme auf:
Das maschinelle Aufsetzen des Deckels auf den Ventilblock bereitet Schwierigkeiten. Die Automatisierung ist nur auf sehr umständliche Weise möglich. Bei dem automatisierten Zusammenbau von Ventilblock und Deckel kommt es zu Zentrierproblemen und zu Dichtungsproblemen.

Weiterhin sind die Befestigung und die Abdichtung der elektrischen Leitungen für die Spulen der Elektromagnetventile problematisch.

Der Erfindung liegen folgende Aufgaben zugrunde:
Es sollen die geschilderten Nachteile des Standes der Technik vermieden werden.

Das Ventilblockaggregat soll einen einfacheren Aufbau erhalten. Die Montage soll erleichtert werden, insbesondere soll eine vereinfachte, automatische Montage des Aggregats möglich werden. Die Herstellung soll kostengünstiger werden. Insbesondere soll das maschinelle Aufsetzen des Deckels auf den Ventilblock erleichtert werden.

Mit der Erfindung soll erreicht werden, daß der Stecker der Schaltung im Deckel integriert ist, das heißt, zusammen mit dem Deckel eine Einheit bildet. Probleme der Abdichtung zwischen Deckel und Stecker sollen dadurch umgangen werden.

Die Erfindung soll eine Grundlage dafür schaffen, daß Stecker und Deckel einstückig ausgebildet werden können. Es ist weiterhin Auigabe der Erfindung, daß Lötvorgänge überflüssig werden und daß damit Lötfehler, die Kosten verursachen, vermieden werden.
Es soll eine Demontierbarkeit des Deckels und der Leiterbahnen möglich sein, damit die Spulen, insbesondere bei auftretenden Defekten, einfach auswechselbar sind.

Es soll weiterhin durch die Erfindung ein Toleranzausgleich zwischen den Kontakten des Deckels und denen der Spulen der Elektromagnetventile erzielt werden. Die Kontaktstellen des Deckels sollen federnd ausgebildet sein.

Es gehört außerdem zu den Aufgaben der Erfindung, daß Montagezeiten eingespart werden sollen und daß das gesamte Leitungssystem kurzschlußsicherer wird.

Es sollen gute Vorraussetzungen für eine Automatisierung der Montage des Deckels erreicht werden, wobei mit der Montage des Deckels in einem auch das Leiterbahnsystem montiert werden soll.

Es soll weiterhin möglich gemacht werden, daß durch nachträgliches Auswechseln des Deckels andere Schaltungen oder Steckerbelegungen, insbesondere im Bereich der Kontaktstellen der Spulen realisierbar werden. Die Erfindung macht sich schließlich zur Aufgabe, daß die Leiterbahnen weitgehend geschützt werden und daß bei der Zwischenmontage möglichst keine Beschädigung der Leiterbahnen auftreten kann.

Schraubverbindungen sollen entfallen. Eine Dichtung zwischen Ventilblock und Deckel soll sich erübrigen. Trotzdem aber sollen die elektrischen Kontakte gegen Feuchtigkeit und Verschmutzung geschützt werden. Es soll eine schnelle und einfache Montage des Deckels durchführbar sein.

Die gestellten Aufgaben werden durch die die Patentansprüche 1 und 6 kennzeichnenden Merkmale gelöst.

Die Erfindung läßt sich auf besonders kostengünstige Weise dadurch realisieren, daß die Stromzuführungsvorrichtung aus Leiterbahnen besteht, die in den Deckel, der vorzugsweise aus Kunststoff besteht, eingespritzt sind.

Zur Reduzierung der Herstellungskosten wird weiterhin vorgeschlagen, daß die Leiterbahnen Teil eines Stanzteils, insbesondere eines Stanzgitters, sind.

Bei der Montage wird ein guter Toleranzausgleich zwischen den Kontaktstellen des Deckels einerseits und der Spulen der Elektromagnetventile andererseits dadurch erreicht, daß das Stanzteil mindestens ein aufgestelltes Ende aufweist, das vorzugsweise federnd ausgebildet ist und ein Kontaktelement für mindestens eine Spule der Elektromagnetventile bildet.

Zur weiteren Vereinfachung der Herstellung wird außerdem vorgeschlagen, daß das Stanzteil ein aufgestelltes, federndes Ende aufweist, das ein Steckverbindungselement, insbesondere einem Kontaktmesser, bildet, das eine elektrische Verbindung des Ventilblockaggregats nach außen herstellt.

Mit der Erfindung werden folgende Vorteile erreicht:
Das Steckverbindungselement, das vom Ventilblock nach außen führt, ist im Deckel des Ventilblocks integriert. Somit entfallen Abdichtungsprobleme. Es sind außerdem keine Lötvorgänge mehr notwendig, dadurch werden Lötfehler und entsprechende Kosten vermieden.

Die federnden Enden des Stanzgitters gewährleisten einen guten Toleranzausgleich bei der Herstellung der elektrischen Verbindung.

Dadurch, daß im Deckel das Stanzgitter integriert ist, wird zusätzliche Montagezeit eingespart, das gesamte System wird kurzschlußsicherer. Die bisher bekannten Lötvorgänge und die damit verbundenen Probleme und Fehler entfallen.

Die Montage des Deckels mit Stanzgitter kann automatisiert werden. Zur Auswechslung defekter Spulen ist es lediglich notwendig, den Deckel mit der integrierten Leiterplatte zu demontieren.

Eine andere erfindungsgemäße Lösung der eingangs gestellten Aufgaben besteht darin, daß der Deckel die Stromzuführungsvorrichtung, insbesondere die Schaltung, bestehend aus elektrischen Leiterbahnen, vorzugsweise zusammen mit dem nach außen führenden Kontaktelement der Stromzuführungsvorrichtung, als integrales Bestandteil umfaßt.

Aufgrund der Erfindung ist es leicht möglich, andere Schaltungen oder Steckerbelegungen zu realisieren, indem nachträglich der Deckel ausgewechselt wird.

Die Leiterbahnen leigen bei der erfindungsgemäßen Anordnung geschützt und können bei der Zwischenmontage nicht so ohne weiteres beschädigt werden.

Eine besonders herstellungsfreundliche Ausführung der Erfindung besteht darin. daß für die Strombeaufschlagung Leiterbahnen vorgesehen sind, die Teil eines Stanzteils, insbesondere eines Stanzgitters, sind.

Dabei kann vorgesehen sein, daß die Leiterbahnen am Deckelboden, vorzugsweise formschlüssig, befestigt sind. Die Befestigungselemente können als Klipse oder als Schnapphaken ausgebildet sein.

Eine besonders kostengünstige Bauweise ergibt sich dadurch, daß das Stanzteil mindestens ein aufgestelltes Ende aufweist, das vorzugsweise federnd ausgebildet ist, und ein Kontaktelement für mindestens eine Spule der Elektromagnetventile bildet.

Zur Herstellung einer elektrischen Verbindung nach außen wird vorgeschlagen, daß das Stanzteil mindestens ein aufgestelltes Ende aufweist, das vorzugsweise federnd ausgebildet ist, und ein Kontaktelement, insbesondere ein federndes Steckerelement, für den elektrischen Kontakt mit einem elektrischen Verbindungsmittel, insbesondere einem Kontaktmesser, bildet.

Zur Vereinfachung der Montage wird vorgeschlagen, daß mindestens ein Befestigungselement ein integrales Teil des Deckels ist.

Als Befestigungselement kann anstelle von Klipsen oder Schnapphaken auch ein Befestigungselement in der Art eines Druckknopfes gewählt werden.

In einer bevorzugten Ausführungsform kann vorgesehen werden, daß ein oder mehrere elektrische Leiter durch elektrisch leitendes Material, insbesondere durch Messingblech, gebildet werden, das im, vorzugsweise aus Kunststoff bestehenden Deckel, eingegossen ist.

Die Kontaktelemente können vorzugsweise Kontaktstifte, auch "Pins" genannt, oder Kontaktstecker sein, die als am leitenden Material angeformte Teile ausgebildet sind.

In einer bevorzugten Ausführungsform wird vorgeschlagen, daß der Deckel als Ganzes auf den Ventilblock aufsetzbar ist, wobei er gleichzeitig alle elektrischen Kontakte herstellt und formschlüssig mit dem Ventilblock verbunden wird.

Die Formschlüssigkeit kann dabei durch Winkelhaken hergestellt werden, die am Deckel befestigt sind und am Ventilblock einrasten können.

In weiterer Ausgestaltung der Erfindung wird vorgeschlagen, daß auf der Innenseite des Deckels angeformte Pins vorgesehen sind, die mit an den Spulen des Ventilblocks angebrachten Steckern eine elektrische Verbindung herstellen.

An der Innenseite des Deckels können in einer alternativen Ausführung Stecker angeformt sein, die mit an den Spulen des Ventilblocks angebrachten Pins elektrische Kontakte bilden. Weiterhin wird vorgeschlagen, daß die elektrischen Leiter im Deckel entsprechend einem Schaltplan vernetzt angeordnet sind und in Verbindung mit einem Mehrfachstecker stehen, der an der Deckelaußenseite angebracht ist.

Um einen Schutz der elektrischen Kontakte zu erreichen, wird vorgeschalgen, daß Moosgummielemente oder Weichgummielemente vorgesehen sind, die die Stecker-Pin-Verbindungen gegen Feuchtigkeit und Schmutz abdichten, und bei der Deckelmontage zwischen Deckel und den Elektromagnetventilen, insbesondere den Spulen der Elektromagnetventile, verklemmbar angeordnet sind.

Mit der Erfindung werden folgende Vorteile erreicht:

Die eingangs geschilderten Nachteile des Standes der Technik werden vermieden.

Es werden verbesserte Voraussetzungen dafür geschaffen, daß der Deckel maschinell auf den Ventilblock aufgesetzt werden kann. Dichtungs- und Zentrierprobleme, die durch bisher bekannte Fertigungs- und Zusammbaumethoden entstanden sind, werden behoben. Es wird eine zuverlässige elektrische Leitungsbefestigung und Leitungsabdichtung geschaffen. Mit Hilfe der Erfindung wird ein Aggregat, bestehend aus Ventilblock und Deckel geschaffen, das nur einen vergleichsweise geringen Platzbedarf hat, und zwar insbesondere dann, wenn der Deckel vom Ventilblock abgehoben werden muß.

Weitere Einzelheiten der Erfindung sind der folgenden Beschreibung von vier Ausführungsbeispielen zu entnehmen, die in der beiliegenden Zeichnung dargestellt sind.

Figur 1 zeigt ein Aggregat, bestehend aus einem Ventilaufnahmekörper und einem dazugehörenden Deckel.

Figur 2 zeigt in geschnittener Teildarstellung das erste Ausführungsbeispiel eines Ventilblockdeckels.

Die Figuren 3 und 4 zeigen einen Ausschnitt des Deckelbodens, der gemäß dem zweiten Ausführungsbeispiel ausgebildet ist.

Die Figuren 5 und 6 zeigen einen Ausschnitt des Deckelbodens, der gemäß dem dritten Ausführungsbeispiel ausgebildet ist.

Figur 7 zeigt die Teilansicht eines Ventilblockaggregats in einer Ausgestaltung gemäß dem zweiten Ausführungsbeispiel.

Figur 8 zeigt die Schnittdarstellung des vierten Ausführungsbeispiels bzw. eines Deckels für einen Ventilaufnahmekörper und den Ventilaufnahmekörper selbst.

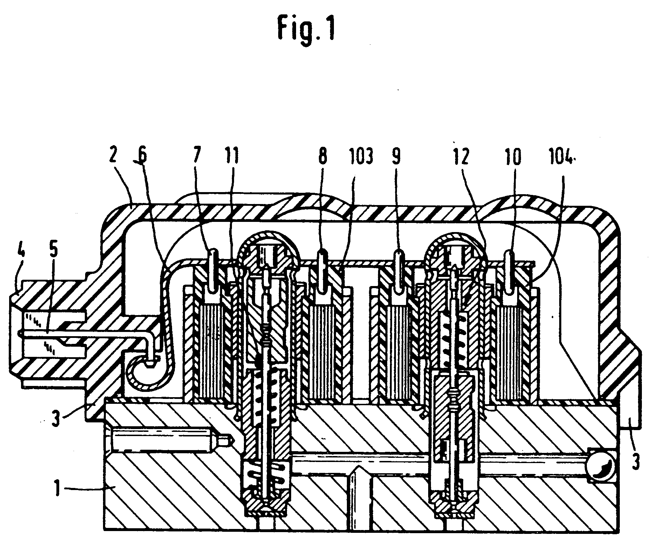

Figur 1 zeigt ein Ventilblockaggregat des Standes der Technik, das durch die Erfindung verbessert werden soll. Das Ventilblockaggregat nach Figur 1 besteht aus einem Ventilaufnahmekörper 1 und einem Deckel 2. Am Deckel 2 befindet sich ein Rahmen und ein Deckelansatz 4 mit einem Kontaktmesser 5. Mit 6 ist eine Anschlußfolie bezeichnet, die Kontaktstifte 7, 8, 9 und 10 mit dem Kontaktmesser verbindet. Die Anschlußfolie enthält entsprechende elektrische Leitungen. Mit 11 ist ein Elektromagnetventil bezeichnet, das stromlos offen ist (SO-Ventil). 12 ist ein Elektromagnetventil, das stromlos geschlossen ist (SG-Ventil).

Bei der Montage des Ventilblockaggregats nach dem Stand der Technik wird wie folgt vorgegangen. Die Elektromagnetventile werden montiert. Anschließend wird die Leiterfolie oder eine Platine aufgelegt und mit den Kontaktstiften verlötet. Schließlich wird mit dem Deckel das Aggregat geschlossen. Dieses Verfahren soll durch die Erfindung verbessert werden.

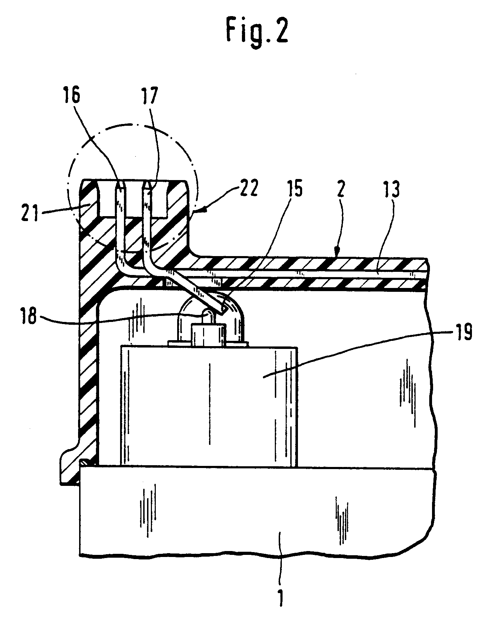

Bei dem Ausführungsbeispiel der Erfindung gemäß Figur 2 sind die Leiterbahnen Teil eines Stanzteils 13. Dieses Stanzteil ist als Stanzgitter ausgebildet. Das Stanzgitter ist im Deckel 14, der aus Kunststoff hergestellt ist, eingespritzt. Die federnden Enden des Stanzgitters 15 sowie die Enden 16, 17 sind als Kontaktelemente ausgebildet. Das aufgestellte Ende 15 ist in federndem Kontakt mit dem Pin 18 der Spule des Elektromagnetventils 19.

Das Elektromagnetventil ist im Ventilblock 20 untergebracht.

Die Enden 16, 17 des Stanzgitters sind als Kontaktmesser ausgebildet. Sie sind innerhalb des Deckelansatzes 21 untergebracht. Die Messer bilden ein Steckverbindungselement für den äußeren Anschluß der Leiterbahnen.

Das Steckverbindungselement ist in seiner Gesamtheit mit 22 bezeichnet.

Beim Stand der Technik, wie er in Figur 1 dargestellt ist, ist es notwendig, daß zuerst die Magnetventile im Stahlventilblock 1 montiert werden. Anschließend wird die Leiterfolie 2 beziehungsweise eine Platine aufgelegt. Anschließend werden die Leiterbahnen mit den Pins der Spulen verlötet. Daran anschließend wird das Aggregat mit dem Deckel 2 verschlossen.
Durch die Erfindung wird erreicht, daß im wesentlichen durch einen Vorgang der Deckel mit sämtlichen Leiterbahnen auf den Ventilblock aufgesetzt wird unter gleichzeitiger Herstellung aller Kontakte zwischen Pins 18 der Spule der Elektromagnete 19 einerseits und den aufgestellten Enden 15 des Stanzteils 13 andererseits.

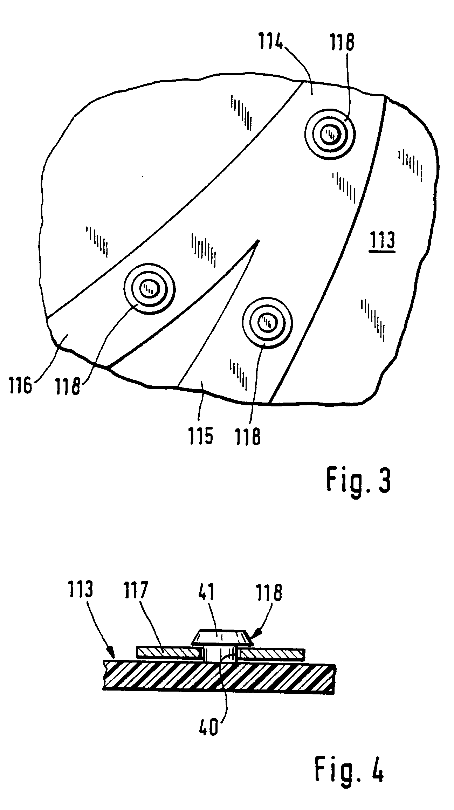

Nach den weiteren Ausführungsbeispielen der Erfindung wird ein Ventilblockdeckel mit integrierter Schaltung und integriertem Stecker vorgeschlagen, die als Ganzes auf den Ventilaufnahmekörper aufgesetzt werden. Bei der Erfindung bestehen die Leiterbahnen aus einem oder mehreren Stanzteilen, beispielsweise aus mehreren Stanzgittern. Diese Stanzteile sind im Deckelboden befestigt. Diese Befestigung, die im nachfolgenden an einem Stanzteil beschrieben wird, erfolgt durch Klipse oder durch Schnapphaken. Weiterhin sind aufgestellte Enden vorgesehen, die einen federnden Kontakt zu den Spulen der Magnetventile und zum Stecker herstellen. Die in den Figuren 3 bis 7 gezeigten Leiterbahnen 114,115,116,117,24,25,26,29,30 sind Teile eines Stanzgitters.

Figur 3 zeigt einen Ausschnitt des Deckelbodens 113. Auf dem Deckelboden sind die Leiterbahnen 114,115,116 angebracht.

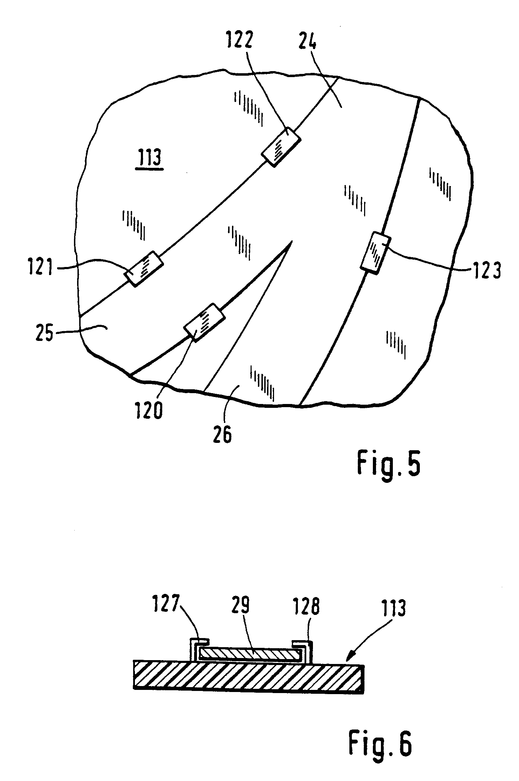

Wie aus Figur 4 ersichtlich, ist die Leiterbahn 117 mit einem Klips 118 am Deckelboden 113 befestigt. Klips und Deckel bestehen aus einem Material. Sie bilden einen Körper. Die Befestigung der Leiterbahn auf dem Deckelboden erfolgt, wie aus Figur 4 ersichtlich, durch deren "Einknöpfen". Einknöpfen bedeutet hier, daß die Leiterbahn 117 über den Kopf 41 des Klips 118 geschoben wird und in der Kröpfung 40 des Klips einrastet. Der Klips und der Deckel sind aus Kunststoff.

Bei dem Ausführungsbeispiel nach den Figuren 5 und 6 werden Schnapphaken 120,121,122,123 verwendet. Mit Hilfe der Schnapphaken werden die Leiterbahnen 24,25,26,29 am Deckelboden 113 befestigt. Die Schnapphaken sind elastisch, sie können in Bezug auf die Leiterbahn nach außen gebogen werden. Die Leiterbahn wird anschließend auf den Deckelboden gelegt. Die Schnapphaken 127,128 bewegen sich aufgrund ihrer Elastizität zurück in ihre Ausgangsposition und sichern so die Leiterbahn (29), siehe Figur 6.

Die Schnapphaken bestehen aus dem gleichen Material (Kunststoff) wie der Deckel und bilden zusammen mit dem Deckel eine körperliche Einheit.

Die Schnapphaken können gegenüberliegend, siehe Schnapphaken 120,121 oder versetzt zueinander, siehe Schnapphaken 122,123, angeordnet sein.

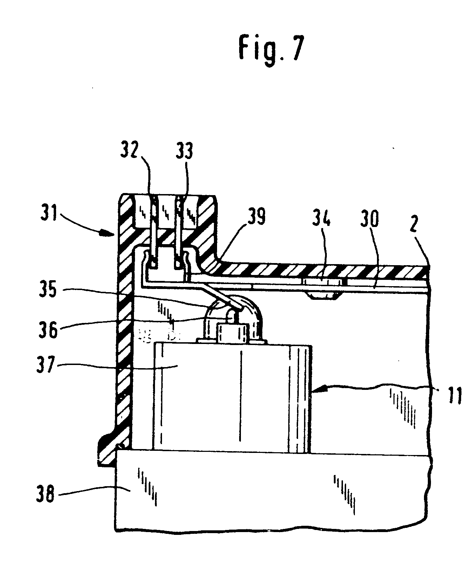

In Figur 7 ist der Deckel 2 geschnitten dargestellt. Er weist einen Deckelansatz 31 auf, der Kontaktmesser 32, 33 beherbergt. Mit 30 ist eine Leiterbahn bezeichnet.

Diese Leiterbahn ist, wie dargestellt, ein Teil eines Stanzgitters. Das Stanzgitter ist daher in Figur 7 ebenfalls mit der Bezugsziffer 30 gekennzeichnet. Das Stanzgitter 30 ist unter anderem durch den Klips 34 am Deckel befestigt.

Die durch das Stanzgitter verkörperten Leiterbahnen besitzen aufgestellte federnde Enden, von denen eins 35 dargestellt ist. Dieses aufgestellte Ende 35 bildet zusammen mit dem Kontaktstift 36 der Spule 37 des Elektromagnetventils 11 einen elektrischen Kontakt. Das Elektromagnetventil 11 ist im Ventilaufnahmekörper 38 untergebracht.

Das Stanzgitter 30 ist im Bereich des Deckelansatzes 31 als federnde Steckvorrichtung 39 ausgebildet. Diese Steckvorrichtung liegt federnd an den Kontaktmessern 32, 33 an. Hierdurch wird eine elektrische Verbindung nach außen hergestellt.

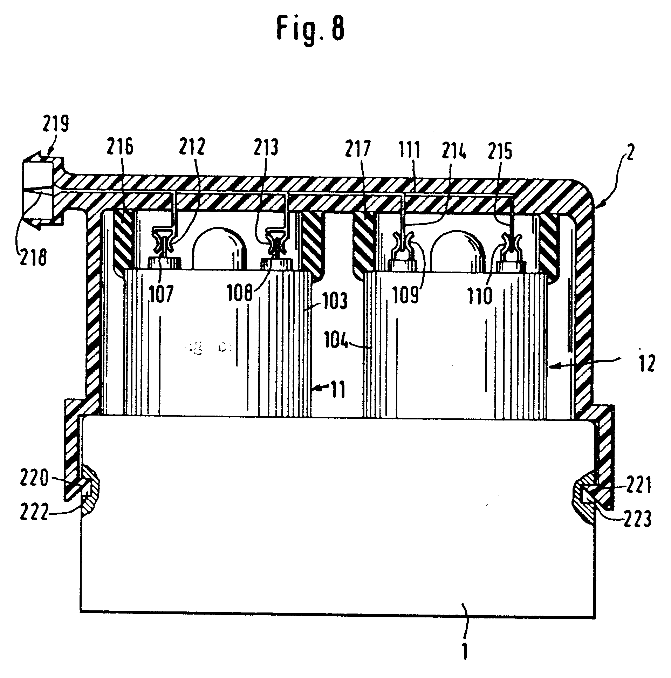

Bei dem in Figur 8 dargestellten Ausführungsbeispiel ist die links angeordnete Spule 103 mit vorgenannten Pins 107, 108 versehen, während bei der rechts angeordneten Spule 104 als Kontaktelemente Stecker 109, 110 vorgesehen sind.

Der Deckel 2 besteht beim vorliegenden Ausführungsbeispiel aus Kunststoff. In den Kunststoffdeckel 2 ist ein Messingblech 111 eingegossen. Dieses Messingblech bildet elektrische Leiter oder Leiterbahnen, die in der Figur ebenfalls mit 111 bezeichnet werden. Durch diese Leiter oder Leiterbahnen 111 werden die Spulen 103, 104 mit Strom beaufschlagt.

Beim vorliegenden Ausführungsbeispiel handelt es sich um Elektromagnetventile 11, 12 für Antiblockieranlagen.

Das im Kunststoff des Deckels 2 eingegossene Messingblech 111 bzw. die aus Messingblech bestehenden Leiter oder Leiterbahnen besitzen angeformte Elemente, die entweder als Stecker 212, 213 oder als Pins 214, 215 ausgebildet sind. Diese Kontaktelemente ragen von der Deckelinnenseite aus gesehen nach innen in Richtung auf den Ventilaufnahmekörper 1.

Die Stecker 212, 213 und Pins 214, 215, die aus dem Deckel 2 herausragen, korrespondieren zu den Pins 107, 108 der Spule 103 bzw. zu den Steckern 109, 110 der Spule 104.

Zwischen dem Deckel 2 und den Spulen 103, 104 ist jeweils ein Weichgummi- oder Moosgummielement 216, 217 angeordnet, das bei der Montage des Deckels 2 auf den Ventilaufnahmekörper 1 abdichtend die Kontaktelemente, d.h. die Stecker und Pins umgibt. Die Moos- oder Weichgummielemente 216, 217 werden zwischen Deckel 2 und Spulen 103, 104 eingeklemmt.

An seiner Außenseite ist der Deckel 2 mit einer Kontaktvorrichtung, insbesondere einem Mehrfachstecker 219 versehen. Durch diesen Mehrfachstecker werden die elektrischen Kontakte durch eine Kontaktleiste oder Messingleiste 218 beispielsweise zu der Ausgangsseite eines elektronischen Reglers eines ABS-Systems hergestellt.

Im Mehrfachstecker 219 enden die aus dem Messingblech 111 gebildeten Leiter oder Leiterbahnen, die im Deckel 2 untergebracht sind, und die die Verbindungen zu den Kontaktelementen der Spulen 103, 104 herstellen.

Der Deckel 2 ist im Bereich seines unteren Randes mit Winkelhaken 220, 221 versehen, die sich elastisch nach außen bewegen lassen.

Korrespondierend zu den Winkelhaken besitzt der Ventilaufnahmekörper 1 Ausnehmungen 222, 223, in die die Winkelhaken bei der Montage des Deckels 2 auf den Ventilblock eingreifen können. Der Deckel wird auf diese Weise am Ventilaufnahmekörper 1 verankert.

Der Aufsetzvorgang des Deckels 2 auf den Ventilaufnahmekörper 1 läuft wie folgt ab:
Der Deckel 2 wird konzentrisch zum Ventilaufnahmekörper 1, insbesondere zu den Steckern 109, 110, 212, 213 oder Pins, 107, 108, 214, 215, die auf den Spulen 103, 104 angebracht sind, auf den Ventilaufnahmekörper 1 aufgesetzt und in Richtung auf den Ventilaufnahmekörper 1 verschoben.

Durch die Verschiebung werden die oben beschriebenen elektrischen Kontakte hergestellt. Der untere Rand des Deckels 2 überfährt den oberen Rand des Ventilaufnahmekörpers 1, bis es zur Einrastung des Winkelhaken 220, 221 in die Ausnehmungen 222, 223 des Ventilaufnahmekörpers 1 kommt.

Auf diese Weise wird eine schnelle, einfache und sichere Montage des Deckels 2 auf den Ventilaufnahmekörper 1 erreicht. Ein Löten ist nicht notwendig, ebenso ist eine Verschraubung überflüssig. Besondere Dichtungen zwischen dem Ventilaufnahmekörper 1 und dem Deckel 2 können entfallen. Trotzdem wird durch die Erfindung eine gute Abdichtung gegenüber Dämpfen, insbesondere aus dem Motorraum, Feuchtigkeit und Schmutz erzielt. Es wird eine hohe Abzugskraft zwischen Ventilaufnahmekörper 1 und Deckel 2 erreicht.

Im Vorangegangenen wurden lediglich vier Ausführungsbeispiele der Erfindung beschrieben. Die Erfindung ist jedoch nicht auf die beschriebenen Ausführungsbeispiele beschränkt. So kann der Grundgedanke der Erfindung auch durch andere elektrische Kontaktelemente verwirklicht werden, die den Kontakt durch Aufschieben eines Elements auf das andere herstellen.

### Bezugszeichenliste

- 1: Ventilaufnahmekörper
- 2: Deckel
- 3: Rahmen
- 4: Deckelansatz
- 5: Kontaktmesser
- 6: Anschlußfolie
- 7: Kontaktstift
- 8: Kontaktstift
- 9: Kontaktstift
- 10: Kontaktstift
- 11: Elektromagnetventil (SO-Ventil)
- 12: Elektromagnetventil (SG-Ventil)
- 14: Deckel
- 15: Ende
- 16: Ende
- 17: Ende
- 18: Pin
- 19: Elektromagnetventil
- 20: Ventilblock
- 21: Deckelansatz
- 22: Steckverbindungselement
- 23: -
- 24: Leiterbahn
- 25: Leiterbahn
- 26: Leiterbahn
- 27: -
- 28: -
- 29: Leiterbahn
- 30: Leiterbahn, Stanzgitter
- 31: Deckelansatz
- 32: Kontaktmesser
- 33: Kontaktmesser
- 34: Klips
- 35: Leiterbahnende
- 36: Stift
- 37: Spule
- 38: Ventilblock
- 39: federnde Steckvorrichtung
- 40: Kröpfung
- 41: Kopf
- 103: Spule
- 104: Spule
- 107: Pin
- 108: Pin
- 109: Stecker
- 110: Stecker
- 111: Messingblech, elektrischer Leiter, Leiterbahn
- 113: Deckelboden
- 114: Leiterbahn
- 115: Leiterbahn
- 116: Leiterbahn
- 117: Leiterbahn
- 118: Klips
- 120: Schnapphaken
- 121: Schnapphaken
- 122: Schnapphaken
- 123: Schnapphaken
- 127: Schnapphaken
- 128: Schnapphaken
- 212: Stecker
- 213: Stecker
- 214: Pin
- 215: Pin
- 216: Gummielement
- 217: Gummielement
- 218: Messerleiste
- 219: Mehrfachstecker
- 220: Winkelhaken
- 221: Winkelhaken
- 222: Ausnehmung
- 223: Ausnehmung

## Patentansprüche

1. Ventilblockaggregat, insbesondere für Bremsdruckregelvorrichtungen, wie Antiblockierregelvorrichtungen, Antriebsschlupfregelvorrichtungen, bestehend aus einem oder mehreren elektromagnetisch betätigbaren Hydraulikventilen (Elektromagnetventilen) (11, 12, 19), einem Ventilblockdeckel (Deckel) (2), einer Stromzuführungsvorrichtung für die Strombeaufschlagung der Spulen (103, 104, 37) der Elektromagnetventile, dadurch **gekennzeichnet,** daß der Deckel (2) aus einem Material besteht, in das elektrische Leitungen untergebracht sind, daß die als Stromzuführungsvorrichtung wirksamen elektrischen Leitungen vom Deckelmaterial gehalten sind, und daß federnde Kontaktelemente (15, 35 212, 213, 109, 110) vorgesehen sind, die die elektrische Verbindung zwischen den Spulen (103, 104, 37) und der Stromzuführungsvorrichtung herstellen.

2. Ventilblockaggregat nach Anspruch 1, dadurch **gekennzeichnet,** daß die Stromzuführungsvorrichtung aus Leiterbahnen (111) besteht, die in den Deckel (2), der vorzugsweise aus Kunststoff besteht, eingespritzt sind.

3. Ventilblockaggregat nach Anspruch 2, dadurch **gekennzeichnet,** daß die Leiterbahnen (111) Teil eines Stanzteils (13), insbesondere eines Stanzgitters, sind.

4. Ventilblockaggregat nach einem oder mehreren der vorangegangenen Ansprüchen, dadurch **gekennzeichnet,** daß das Stanzteil (13) mindestens ein aufgestelltes Ende (15) aufweist, das vorzugsweise federnd ausgebildet ist, und ein Kontaktelement für mindestens eine Spule der Elektromagnetventile (19) bildet.

5. Ventilblockaggregat nach einem oder mehreren der vorangegangenen Ansprüche, dadurch **gekennzeichnet,** daß das Stanzteil (13) mindestens ein aufgestelltes Ende (16, 17) aufweist, das vorzugsweise federnd ausgebildet ist, und ein elektrisches Kontaktelement für ein Steckverbindungselement (22), insbesondere ein Kontaktmesser, bildet, das eine elektrische Verbindung des Ventilblockaggregats nach außen herstellt.

6. Ventilblockaggregat, insbesondere für Bremsdruckregelvorrichtungen, wie Antiblockierregelvorrichtungen, Antriebsschlupfregelvorrichtungen, bestehend aus einem oder mehreren elektromagnetisch betätigbaren Hydraulikventilen (Elektromagnetventilen) (11, 12, 19), einem Ventilblockdeckel (Deckel) (2), einer Stromzuführungsvorrichtung für die Strombeaufschlagung der Spulen (103, 104, 37) der Elektromagnetventile, dadurch **gekennzeichnet,** daß der Deckel (2) die Stromzuführungsvorrichtung, die Schaltung, bestehend aus elektrischen Leiterbahnen (30, 114, 115, 116, 117), zusammen mit dem in Bezug auf das Ventilblockaggregat nach außen führenden Kontaktelement der Stromzuführungsvorrichtung, als integrales Bestandteil umfaßt.

7. Ventilblockaggregat nach Anspruch 6, dadurch **gekennzeichnet,** daß für die Strombeaufschlagung Leiterbahnen (114 - 117) vorgesehen sind, die Teil eines Stanzteils (13), insbesondere eines Stanzgitters sind.

8. Ventilblockaggregat nach Anspruch 6 oder 7, dadurch **gekennzeichnet,** daß die Leiterbahnen (114 bis 117) am Deckelboden (113), vorzugsweise formschlüssig befestigt sind.

9. Ventilblockaggregat nach einem oder mehreren der Ansprüche 6 bis 8, dadurch **gekennzeichnet,** daß mindestens ein Befestigungselement als Klips (118) ausgebildet ist.

10. Ventilblockaggregat nach einem oder mehreren der vorangehenden Ansprüche 6 bis 9, dadurch **gekennzeichnet,** daß mindestens ein Befestigungselement als Schnapphaken (120,121,122,123,127) ausgebildet ist.

11. Ventilblockaggregat nach einem oder mehreren der vorangehenden Ansprüche 6 bis 10, dadurch **gekennzeichnet,** daß das Stanzteil (30) mindestens ein aufgestelltes Ende (35) aufweist, das vorzugsweise federnd ausgebildet ist und ein Kontaktelement für mindestens eine Spule (37) der Elektromagnetventile bildet.

12. Ventilblockaggregat nach einem oder mehreren der vorangehenden Ansprüche 6 bis 10, dadurch **gekennzeichnet,** daß das Stanzteil (30) mindestens ein aufgestelltes Ende aufweist, das vorzugsweise federnd ausgebildet ist, und ein Kontaktelement, insbesondere ein federndes Steckelement (39), für den elektrischen Kontakt mit einem elektrischen Verbindungsmittel, insbesondere einem Kontaktmesser (32, 33), bildet, das eine elektrische Verbindung des Ventilblockaggregats nach außen herstellt.

13. Ventilblockaggregat nach einem oder mehreren der vorangehenden Ansprüche 6 bis 12, dadurch **gekennzeichnet,** daß mindestens ein Befestigungselement ein Teil des Deckels ist.

14. Ventilblockaggregat nach einem oder mehreren der vorangehenden Ansprüche 6 bis 13, dadurch **gekennzeichnet,** daß mindestens ein Befestigungselement in der Art eines Druckknopfs ausgebildet ist.

15. Ventilblockaggregat nach mindestens einem der vorhergehenden Ansprüche, dadurch **gekennzeichnet,** daß ein oder mehrere elektrische Leiter oder Leiterbahnen (111) durch ein elektrisch leitendes Material, durch Messingblech, gebildet werden, das aus Kunststoff bestehenden Deckel (2), eingegossen ist.

16. Ventilblockaggregat nach einem oder mehreren der vorangegangenen Ansprüche, dadurch **gekennzeichnet,** daß die Kontaktelemente, die Kontaktstifte (Pins) oder Kontaktstecker (Stecker), aus am leitenden Material angeformten Teilen (214, 215, 212, 213) bestehen.

17. Ventilblockaggregat nach einem oder mehreren oder vorangegangenen Ansprüche, dadurch **gekennzeichnet,** daß der Deckel (2) auf den Ventilblock (201) aufsetzbar, gleichzeitig alle elektrischen Kontakte schließend und sich, formschlüssig, mit dem Ventilaufnahmekörper (1) verbindend ausgebildet ist.

18. Ventilblockaggregat nach mindestens einem der vorhergehenden Ansprüche, dadurch **gekennzeichnet,** daß der Deckel (2) auf dem Ventilaufnahmekörper (1), durch Winkelhaken (220, 221) einrastbar ausgebildet ist.

19. Ventilblockaggregat nach einem oder mehreren der vorangegangenen Ansprüche, dadurch **gekennzeichnet,** daß im Deckel (2) angeformte Pins (214, 215) vorgesehen sind, die mit an der Spule (204) des Ventilblocks angebrachten Steckern (109, 110) eine elektrische Verbindung herstellen.

20. Ventilblockaggregat nach einem oder mehreren der vorangegangenen Ansprüche, dadurch **gekennzeichnet,** daß im Deckel (2) Stecker (212, 213) angeformt sind, die mit an der Spule (203) des Ventilaufnahmekörpers (1) angebrachten Pins (107, 108) elektrische Kontakte herstellen.

21. Ventilblockaggregat nach einem oder mehreren der vorangegangenen Ansprüche, dadurch **gekennzeichnet,** daß die elektrischen Leiter (111) im Deckel (2) entsprechend einem vorgegebenen Schaltplan vernetzt angeordnet sind und in Verbindung mit einem Mehrfachstecker (219) stehen, der an der Außenseite des Deckels (2) angeordnet ist.

22. Ventilblockaggregat nach einem oder mehreren der vorangegangenen Ansprüche, dadurch **gekennzeichnet,** daß Moosgummielemente oder Weichgummielemente (216, 217) vorgesehen sind, die die elektrischen Kontakte, die Stecker-Pin-Verbindungen, gegen Feuchtigkeit, Dämpfe und Schmutz abdichtend und bei der Deckelmontage zwischen Deckel (2) und den Elektromagnetventilen, den Spulen (203, 204) der Elektromagnetventile, verklemmbar angeordnet sind.

## Claims

1. A valve block assembly, in particular for braking pressure regulating devices, such as anti-lock control devices, traction slip control devices, composed of one or more electromagnetically actuatable hydraulic valves (solenoid valves) (11, 12, 19), a valve block cover (cover) (2), a power-supply means for energizing the coils (103, 104, 37) of the solenoid valves,
**characterized** in that the cover (2) is made of a material in which electrical lines are accommodated, in that the electrical lines effective as power-supply means are retained by the cover material, and in that resilient contact elements (15, 35, 212, 213, 109, 110) are provided which establish the electrical connection between the coils (103, 104, 37) and the power-supply means.

2. A valve block assembly as claimed in claim 1,
**characterized** in that the power-supply means is composed of conducting paths (111) which are injection-moulded in the cover (2) that is preferably composed of plastics.

3. A valve block assembly as claimed in claim 2,
**characterized** in that the conducting paths (111) are part of a stamping (13), in particular a stamped grid.

4. A valve block assembly as claimed in any one or more of the preceding claims,
**characterized** in that the stamping (13) includes at least one erected end (15) which, preferably, is of resilient design and forms a contact element for at least one coil of the solenoid valves (19).

5. A valve block assembly as claimed in any one or more of the preceding claims,
**characterized** in that the stamping (13) includes at least one erected end (16, 17) which, preferably, is of resilient design and which forms an electrical contact element for a plug-connector element (22), in particular a contact blade, which constitutes an electrical connection of the valve block assembly to the outside.

6. A valve block assembly, in particular for braking pressure regulating devices, such as anti-lock control devices, traction slip control devices, composed of one or more electromagnetically actuatable hydraulic valves (solenoid valves) (11, 12, 19), a valve block cover (cover) (2), a power-supply means for energizing the coils (103, 104, 37) of the solenoid valves,
**characterized** in that the cover (2) comprises as an integral component part the power-supply means, the circuitry composed of electrical conducting paths (30, 114, 115, 116, 117), together with the contact element of the power-supply means which leads outwardly in respect of the valve block assembly.

7. A valve block assembly as claimed in claim 6,
**characterized** in that conducting paths (114 to 117) are provided for the energization which are part of a stamping (13), in particular a stamped grid.

8. A valve block assembly as claimed in claim 6 or 7,
**characterized** in that the conducting paths (114 to 117) are fixed to the cover bottom (113), preferably in positive engagement therewith.

9. A valve block assembly as claimed in any one or more of the claims 6 to 8,
**characterized** in that at least one fixing element is designed as a clip (118).

10. A valve block assembly as claimed in any one or more of the preceding claims 6 to 9,
**characterized** in that at least one fixing element is designed as a snap hook (120, 121, 122, 123, 127).

11. A valve block assembly as claimed in any one or more of the preceding claims 6 to 10,
**characterized** in that the stamping (30) comprises at least one erected end (35) which, preferably, is of resilient design and forms a contact element for at least one coil (37) of the solenoid valves.

12. A valve block assembly as claimed in any one or more of the preceding claims 6 to 10,
**characterized** in that the stamping (30) comprises at least one erected end which, preferably, is of resilient design, and forms a contact element, in particular a resilient plug element (39), for the electrical contact with an electrical connecting means, in particular a contact blade (32, 33) which establishes an electrical connection of the valve block assembly to the outside.

13. A valve block assembly as claimed in any one or more of the preceding claims 6 to 12,
**characterized** in that at least one fixing element is a part of the cover.

14. A valve block assembly as claimed in any one or more of the preceding claims 6 to 13,
**characterized** in that at least one fixing element is designed in the type of a press fastener.

15. A valve block assembly as claimed in at least one of the preceding claims,
**characterized** in that one or more electric conductors or conducting paths (111) are formed by an electrically conductive material, by sheet brass, which is cast in the cover (2) consisting of plastics.

16. A valve block assembly as claimed in any one or more of the preceding claims,
**characterized** in that the contact elements, the contact pins (pins) or contact plugs (plugs) are designed as parts (214, 215, 212, 213) shaped on the conductive material.

17. A valve block assembly as claimed in any one or more of the preceding claims,
**characterized** in that the cover (2) can be mounted on the valve block (201), while it simultaneously establishes all electrical contacts and is connected with the valve-receiving member (1), especially in positive engagement therewith.

18. A valve block assembly as claimed in at least one of the preceding claims,
**characterized** in that the cover (2) is arranged to be engaged on the valve-receiving member (1) by means of angle bars (220, 221).

19. A valve block assembly as claimed in any one or more of the preceding claims,
**characterized** in that pins (214, 215) are provided which are shaped in the cover (2) and which establish an electrical connection with plugs (109, 110) fitted on the coil (204) of the valve block.

20. A valve block assembly as claimed in any one or more of the preceding claims,
**characterized** in that plugs (212, 213) are shaped in the cover (2) which form electrical contacts with pins (107, 108) mounted on the coil (203) of the valve-receiving member (1).

21. A valve block assembly as claimed in any one or more of the preceding claims,
**characterized** in that the electric conductors (111) in the cover (2) are interlaced according to a predetermined wiring arrangement and are in connection with a multiple plug assembly (219) mounted on the outside of the cover (2).

22. A valve block assembly as claimed in any one or more of the preceding claims,
**characterized** in that rubber-sponge elements or soft-rubber elements (216, 217) are provided which seal the electrical contacts, the plug-and-pin connections, against moisture, fumes and dirt and which are placed in a fashion able to get jammed during the cover assembly between the cover (2) and the solenoid valves, the coils (203, 204) of the solenoid valves.

## Revendications

1. Ensemble de bloc de valves, notamment pour des dispositifs de régulation de pression de freinage, tels que des dispositifs de régulation antiblocage et des dispositifs de régulation du glissement de traction, constitué d'une ou plusieurs valves hydrauliques à actionnement électromagnétique (électrovalves) (11, 12, 19), d'un couvercle de bloc de valves (couvercle) (2) et d'un dispositif d'amenée de courant servant à alimenter en courant les bobines (103, 104, 37) des électrovalves, caractérisé en ce que le couvercle (2) est réalisé dans une matière dans laquelle les conducteurs électriques sont disposés, en ce que les conducteurs électriques servant de dispositif d'alimentation en courant sont maintenus par la matière du couvercle et en ce qu'il est prévu des éléments élastiques de contact (15, 35, 212, 213, 109, 110) qui réalisent la liaison électrique entre les bobines (103, 104, 37) et le dispositif d'alimentation en courant.

2. Ensemble de bloc de valves suivant la revendication 1, caractérisé en ce que le dispositif d'amenée de courant est constitué de pistes conductrices (111) qui sont noyées dans le couvercle (2) à l'injection, lequel est de préférence en matière plastique.

3. Ensemble de bloc de valves suivant la revendication 2, caractérisé en ce que les pistes conductrices (111) font partie d'une pièce réalisée par découpage à l'emporte-pièce (13), notamment d'une grille réalisée par découpage à l'emporte-pièce.

4. Ensemble de bloc de valves suivant une ou plusieurs des revendications précédentes, caractérisé en ce que la pièce réalisée par découpage à l'emporte-pièce (13) comprend au moins une extrémité redressée (15) qui est réalisée de préférence de façon à présenter un comportement élastique et qui constitue un élément de contact pour au moins une bobine des électrovalves (19).

5. Ensemble de bloc de valves suivant une ou plusieurs des revendications précédentes, caractérisé en ce que la pièce réalisée par découpage à l'emporte-pièce (13) comporte au moins une extrémité redressée (16, 17) qui est de préférence réalisée de façon à avoir un comportement élastique et qui constitue un élément de contact électrique pour un élément de liaison par enfichage (22), notamment un contact à couteau, qui réalise une liaison électrique de l'ensemble de bloc de valves vers l'extérieur.

6. Ensemble de bloc de valves, notamment pour des dispositifs de régulation de pression de freinage, tels que des dispositifs de régulation antiblocage et des dispositifs de régulation du glissement de traction, constitué d'une ou plusieurs valves hydrauliques à actionnement électromagnétique (électrovalves) (11, 12, 19), d'un couvercle de bloc de valves (couvercle) (2) et d'un dispositif d'amenée de courant servant à alimenter en courant les bobines (103, 104, 37) des électrovalves, caractérisé en ce que le couvercle (2) entoure, sous la forme d'une pièce unitaire, le dispositif d'amenée de courant, le circuit, constitué de pistes conductrices de l'électricité (30, 114, 115, 116, 117), en commun avec l'élément de contact du dispositif d'amenée de courant qui mène vers l'extérieur par rapport à l'ensemble de bloc de valves.

7. Ensemble de bloc de valves suivant la revendication 6, caractérisé en ce que, pour l'alimentation en courant, il est prévu des pistes conductrices (114-117) qui font partie d'une pièce réalisée par découpage à l'emporte-pièce (13), notamment d'une grille réalisée par découpage à l'emporte-pièce.

8. Ensemble de bloc de valves suivant la revendication 6 ou 7, caractérisé en ce que les pistes conductrices (114 à 117) sont fixées sur le fond du couvercle (113), de préférence par complémentarité de formes.

9. Ensemble de bloc de valves suivant une ou plusieurs des revendications 6 à 8, caractérisé en ce qu'au moins un élément de fixation est réalisé sous la forme d'une agrafe (118).

10. Ensemble de bloc de valves suivant une ou plusieurs des revendications précédentes 6 à 9, caractérisé en ce qu'au moins un élément de fixation est réalisé sous la forme d'un crochet à enclenchement rapide (120, 121, 122, 123, 127).

11. Ensemble de bloc de valves suivant une ou plusieurs des revendications précédentes 6 à 10, caractérisé en ce que la pièce réalisée par découpage à l'emporte-pièce (30) comprend au moins une extrémité redressée (35) qui est de préférence réalisée de façon à avoir un comportement élastique et qui constitue un élément de contact pour au moins une bobine (37) des électrovalves.

12. Ensemble de bloc de valves suivant une ou plusieurs des revendications précédentes 6 à 10, caractérisé en ce que la pièce réalisée par découpage à l'emporte-pièce (30) comporte au moins une extrémité redressée qui est réalisée de préférence de façon à avoir un comportement élastique et qui constitue un élément de contact, notamment un élément d'enfichage à comportement élastique (39), pour le contact électrique avec un moyen de liaison électrique, notamment un contact à couteau (32, 33), qui réalise une liaison électrique de l'ensemble de bloc de valves vers l'extérieur.

13. Ensemble de bloc de valves suivant une ou plusieurs des revendications précédentes 6 à 12, caractérisé en ce qu'au moins un élément de fixation constitue une partie du couvercle.

14. Ensemble de bloc de valves suivant une ou plusieurs des revendications précédentes 6 à 13, caractérisé en ce qu'au moins un élément de fixation est réalisé à la façon d'un bouton-poussoir.

15. Ensemble de bloc de valves suivant au moins l'une des revendications précédentes, caractérisé en ce qu'un ou plusieurs conducteurs électriques ou pistes conductrices (111) sont formés en un matériau conducteur de l'électricité, en tôle de laiton qui est mis en place à la coulée dans le couvercle (2), lequel est en matière plastique.

16. Ensemble de bloc de valves suivant une ou plusieurs des revendications précédentes, caractérisé en ce que les éléments de contact, ergots de contact (pins) ou contacts par enfichage (connecteurs), sont constitués de pièces (214, 215, 212, 213) venues au formage sur la matière conductrice.

17. Ensemble de bloc de valves suivant une ou plusieurs des revendications précédentes, caractérisé en ce que le couvercle (2) est agencé de façon à pouvoir être posé comme un tout sur le bloc de valves (201), en réunissant en même temps tous les contacts électriques et en étant réalisé de façon à pouvoir être relié, par complémentarité de formes, au corps de logement de valves (1).

18. Ensemble de bloc de valves suivant au moins l'une des revendications précédentes, caractérisé en ce que le couvercle (2) est agencé de façon à pouvoir être placé par enclenchement sur le corps de logement de valves (1) à l'aide de crochets coudés (220, 221).

19. Ensemble de bloc de valves suivant une ou plusieurs des revendications précédentes, caractérisé en ce qu'il est prévu, dans le couvercle (2), des ergots (214, 215) venus au formage qui réalisent une liaison électrique avec des connecteurs (109, 110) montés sur la bobine (204) du bloc de valves.

20. Ensemble de bloc de valves suivant une ou plusieurs des revendications précédentes, caractérisé en ce que des connecteurs (212, 213) sont réalisés au formage dans le couvercle (2), ces connecteurs constituant des contacts électriques avec des ergots (107, 108) montés sur la bobine (203) du corps de logement de valves (1).

21. Ensemble de bloc de valves suivant une ou plusieurs des revendications précédentes, caractérisé en ce que les conducteurs électriques (111) sont disposés dans le couvercle (2) en formant un réseau qui correspond au plan de circuit prédéterminé et sont en liaison avec un connecteur multiple (219) qui est disposé sur la face extérieure du couvercle (2).

22. Ensemble de bloc de valves suivant une ou plusieurs des revendications précédentes, caractérisé en ce qu'il est prévu des éléments en caoutchouc mousse ou des éléments en caoutchouc souple (216, 217) qui assurent l'étanchéité des contacts électriques, les liaisons connecteurs-ergots, vis-à-vis de l'humidité, des vapeurs et des souillures et qui sont disposés de façon à pouvoir être serrés, lors du montage du couvercle, entre le couvercle (2) et les électrovalves, les bobines (203, 204) des électrovalves.
